# EUROPÄISCHE PATENTSCHRIFT

(11) **EP 2 338 227 B1**
(45) Veröffentlichungstag und Bekanntmachung des Hinweises auf die Patenterteilung: **13.11.2013**
(21) Anmeldenummer: 09781981.7
(22) Anmeldetag: 19.08.2009
(51) Int. Cl.: H03K 17/16

(54) **VERFAHREN UND VORRICHTUNG ZUR REDUZIERUNG ELEKTROMAGNETISCHER EMISSIONEN BEIM EINSCHALTVORGANG EINES LEISTUNGSHALBLEITERS**
METHOD AND DEVICE FOR REDUCING ELECTROMAGNETIC EMISSIONS DURING THE SWITCH-ON OF A POWER SEMICONDUCTOR
PROCÉDÉ ET DISPOSITIF DE RÉDUCTION D'ÉMISSIONS ÉLECTROMAGNÉTIQUES LORS DE LA MISE SOUS TENSION D'UN SEMI-CONDUCTEUR DE PUISSANCE

(30) Priorität: 16.10.2008 DE 102008042895
(43) Veröffentlichungstag der Anmeldung: 29.06.2011
(73) Patentinhaber: Robert Bosch GmbH, 70442 Stuttgart (DE)
(72) Erfinder: HEIMBURGER, Stefan, 77731 Willstaett-Legelshurst (DE)
(86) Internationale Anmeldenummer: PCT/EP2009/060709
(87) Internationale Veröffentlichungsnummer: WO 2010/043437

(56) Entgegenhaltungen:
- JP-A- 2008 022 451
- US-A1- 2002 070 772
- GRBOVIC, P.J.: "An IGBT Gate Driver for Feed-Forward Control of Turn-on Losses and Reverse Recovery Current" IEEE TRANSACTIONS ON POWER ELECTRONICS, Bd. 23, Nr. 2, März 2008 (2008-03), Seiten 643-652, XP002559612

## Beschreibung

Die Erfindung betrifft ein Verfahren zur Reduzierung elektromagnetischer Emissionen beim Einschaltvorgang eines Leistungshalbleiters sowie eine Vorrichtung zur Durchführung des Verfahrens nach der Gattung der unabhängigen Ansprüche.

### Stand der Technik

Werden elektrische Verbraucher, insbesondere induktive Verbraucher wie Elektromotoren oder dergleichen, mittels einer aus Leistungshalbleitern bestehenden Treiberstufe - beispielsweise über eine Pulsweitenmodulation (PWM) - angesteuert, so kommt es beim Einschalten der Leistungshalbleiter in der Regel zu elektromagnetischen Störemissionen. Diese resultieren aus Oberwellen, die bei einem harten Schaltvorgang entstehen, zu dessen Beginn der kapazitive Eingang des Leistungshalbleiters mit einem Spannungssprung beaufschlagt wird und dann spontan ein sehr hoher Strom in die Eingangselektrode des Leistungshalbleiters fließt. Beim Betreiben von Elektromotoren hat dies Verschiebeströme in der Wicklung des Motors zur Folge. Würde man den Schaltvorgang verlangsamen, so bedeutet dies zwar eine Verringerung der Störemission, aber auch eine Erhöhung der Verlustleistung innerhalb des Leistungshalbleiters, die ihrerseits zu einer erhöhten Erwärmung führt und demzufolge eine aufwändigere und teurere Kühlung erfordert. Umgekehrt führt ein schnelleres Schalten des Leistungshalbleiters zur zu einer reduzierten Verlustleistung, aber auch zu stärkeren Störemissionen. Da letztere in der Regel ein bestimmtes Maß nicht überschreiten dürfen, erfolgt die Lösung dieses Problems vielfach zu ungunsten der Verlustleistung in der Treiberstufe, so dass diese zumindest zeitweise im Bereich ihrer Grenztemperatur betrieben wird. Bekannte Ansteuerverfahren sind daher lediglich in der Lage, die Störemmissionen nur begrenzt zu reduzieren.

Aus der DE 100 61 563 B4 ist ein Verfahren zum Schalten eines Leistungshalbleiters bekannt, bei dem die zeitlichen Verläufe eines durch den Leistungshalbleiter fließenden Laststromes sowie einer über dem Leistungshalbleiterschalter abfallenden Spannung während des Schaltvorgangs geregelt werden. Dazu erfolgt die Regelung des zeitlichen Verlaufs der Spannung und des Laststroms zueinander derart zeitversetzt, das bei Einschalten des Leistungshalbleiters zunächst der zeitliche Verlauf des Laststroms und beim Erreichen eines Maximalwertes des Laststromes der zeitliche Verlauf der Spannung geregelt wird. Die beiden Regelkreise zur Regelung des zeitlichen Verlaufs der Spannung bzw. des Stroms umfassen jeweils eine Korrekturschaltung, die die nichtlineare Übertragungscharakteristik des Leistungshalbleiters linearisiert. Als Leistungshalbleiter kommen entweder MOSFET oder IGBT zum Einsatz. Das in der DE 100 61 563 B4 vorgeschlagene Verfahren ermöglicht zum Einen eine Begrenzung der elektromagnetischen Störemissionen sowie eine Reduzierung der Überspannung beim Ausschaltvorgang. Gleichzeitig gewährleistet es eine erhebliche Reduzierung der Schaltverlustleistung gegenüber bisherigen, einfachen Ansteuerverfahren. Nachteilig ist jedoch die verhältnismäßig hohe Komplexität der beiden Regelkreise und der Korrekturschaltung zur Linearisierung, die einen nicht unerheblichen Kosteneinsatz erfordert.

Aus "An IGBT Gate Driver for Feed-Forward Control of Turn-on Losses and Reverse Recovery Current, Petar J. Grbovic" (IEEE Transactions On Power Electronics, Vol. 23, No. 2, March 2008) ist ferner bekannt, das Gate eines MOSFET oder IGB mit einem Gatestrom in zwei aufeinander folgenden Halbwellen anzusteuern.

### Offenbarung der Erfindung

Das erfindungsgemäße Verfahren zur Reduzierung elektromagnetischer Emissionen beim Einschaltvorgang eines Leistungshalbleiters sowie die entsprechende Vorrichtung zur Durchführung des Verfahrens bieten gegenüber dem Stand der Technik den Vorteil einer einfachen Stromvorsteuerung, die gegenüber aufwändigen Regelverfahren eine deutlich reduzierte Komplexität bei vergleichbarer Störemission und Verlustleistung aufweist und robust ist gegenüber unterschiedlichen Arbeitspunkten, Temperatureffekten und Toleranzen. Dazu steuert der Leistungshalbleiter eine Last derart an, dass nach dem Einschalten ein Laststrom durch die Last und den Leistungshalbleiter fließt, dessen Sättigungswert einen Arbeitspunkt des Leistungshalbleiters definiert, wobei sich für unterschiedliche Sättigungswerte des Laststroms unterschiedliche Arbeitspunkte des Leistungshalbleiters ergeben. Die Sättigungswerte hängen in erster Linie von der Auslegung der jeweiligen Applikation, d.h. beispielsweise von der Belastbarkeit der Last, ab. Eine weitere obere Grenze ist zudem durch die Belastbarkeit des Leistungshalbleites selbst gegeben. Weiterhin wird ein durch die Stromvorsteuerung vorgegebener Steuerstrom im Wesentlichen in mindestens zwei aufeinanderfolgende Halbwellen aufgeteilt. Erfindungsgemäß folgt für den Arbeitspunkt des Leistungshalbleiters, der dem höchstem Sättigungswert des Laststroms entspricht, nach einer ersten Halbwelle dann eine weitere Halbwelle, wenn der Laststrom in etwa seinen Maximalwert erreicht hat.

Die Robustheit des erfindungsgemäßen Verfahren gegenüber unterschiedlichen Arbeitspunkten des Leistungshalbleiters wird dadurch deutlich, dass die zeitliche Aufteilung der Halbwellen des Steuerstroms bei Arbeitspunkten des Leistungshalbleiters, die geringeren Sättigungswerten als dem höchsten Sättigungswert entsprechen, unverändert bleiben kann. Somit ist keine Anpassung der Vorsteuerung an unterschiedliche Applikationen notwendig, was zu einem sehr universellen Einsatz des Verfahrens führt.

In vorteilhafter Weise ist die erste Halbwelle in etwa abgeklungen, bevor der Leistungshalbleiter mit der weiteren Halbwelle beaufschlagt wird. Dazu entsprechen die Halbwellen des Steuerstroms jeweils nahezu einer positiven Sinushalbwelle.

Mit Erreichen des Maximalwertes durch den Laststrom ist es für ein beschleunigtes Schaltverhalten besonders von Vorteil, wenn die zweite Halbwelle des Steuerstroms eine größere Amplitude und/oder eine geringere Dauer aufweist als die erste Halbwelle. Ist der Leistungshalbleiter als ein MOSFET oder ein IGBT ausgebildet, so erreicht die über den MOSFET oder IGBT abfallende Spannung zu diesem Zeitpunkt das so genannte Miller-Plateau, das durch kapazitive Effekte des Leistungshalbleiter-Steuereingangs hervorgerufen wird. Erst wenn dieses Spannungsplateau erreicht ist, kann durch eine entsprechend ausgelegte zweite Halbwelle des Steuerstroms der Schaltvorgang beschleunigt werden.

Um die Präzision des Einschaltvorgangs und die Temperarturstabilität der Treiberstufe weiter zu erhöhen sowie etwaige Schaltstreuungen zu reduzieren, ist es weiterhin vorteilhaft, wenn die Vorsteuerung durch eine einfach Regelung, beispielsweise durch einen PI-Regler oder dergleichen, unterlagert ist, deren Regelgröße die Drain-Source-Spannung oder der Drainstrom bzw. der Laststrom ist.

Weitere Vorteile der Erfindung ergeben sich durch die in den abhängigen Ansprüchen angegebenen Merkmale sowie aus der Zeichnung und der nachfolgenden Beschreibung.

### Zeichnung

Die Erfindung wird im Folgenden anhand der Figuren 1 bis 4 beispielhaft erläutert, wobei gleiche Bezugszeichen in den Figuren auf gleiche Bestandteile mit einer gleichen Funktionsweise hindeuten.

### Es zeigen

Fig. 1: ein Blockschalbild einer Vorrichtung zur Durchführung des erfindungsgemäßen Verfahrens,
Fig. 2: jeweils ein Diagramm des Steuerstroms (oben) und der Steuerspannung (unten) in Abhängigkeit von der Zeit,
Fig. 3: jeweils ein Diagramm des Laststroms (oben) und der über dem Leistungshalbleiter abfallenden Spannung (unten) in Abhängigkeit von der Zeit und
Fig. 4: ein Diagramm der Störemmission in Abhängigkei von der Frequenz.

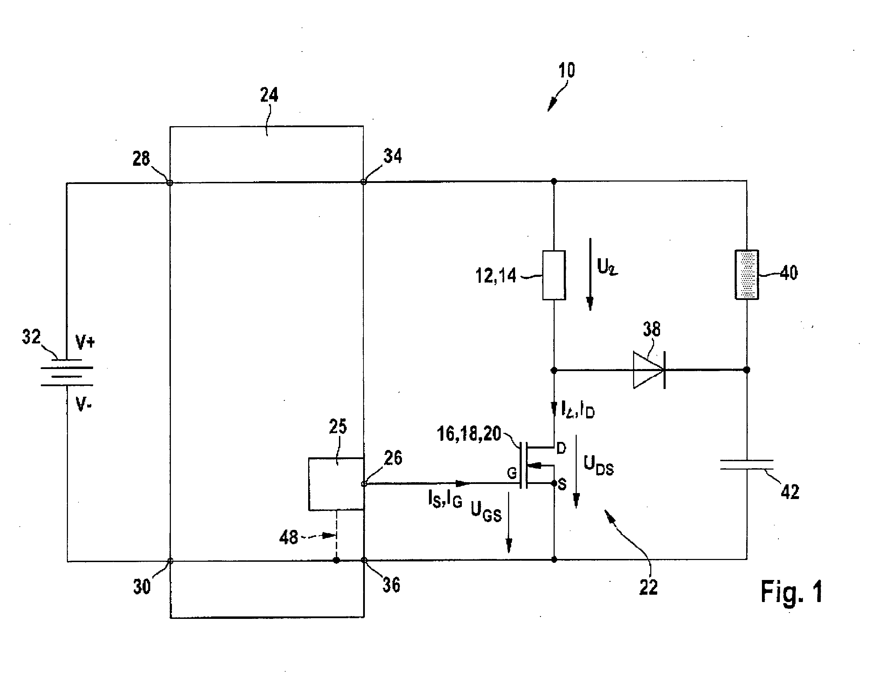

In Figur 1 ist ein Blockschaltbild einer Vorrichtung 10 zur Ansteuerung einer elektrischen Last 12, beispielsweise einer Wicklung 14 eines nicht näher gezeigten Elektromotors, mittels eines in Reihe zu der Last 12 geschalteten Leistungshalbleiters 16 gezeigt. Dabei kann als Leistungshalbleiter 16 beispielsweise ein Metall Oxide Semiconductor Field Effect Transistor (MOSFET) 18 oder ein Insulated Gate Bipolar Transistor (IGBT) 20 zum Einsatz kommen. Da derartige Leistungshalbleiter dem Fachmann bekannt sind, sollen sie hier nicht näher spezifiziert werden. Ohne Einschränkung der Erfindung soll im Folgenden stets von einem Power-MOSFET 18 als Leistungshalbleiter 16 ausgegangen werden.

Der Power-MOSFET 18 ist Bestandteil einer Treiberstufe 22, die beispeilsweise als eine H-Brücke oder eine B-Schaltung zur Ansteuerung eines nicht gezeigten, mehrphasigen Elektromotors mit mehreren Power-MOSFETs 18 ausgebildet sein kann. Zur Vereinfachung wird hier lediglich ein einziger Power-MOSFET 18 dargestellt. Dem Fachmann ist jedoch hinlänglich bekannt, wie derartige Treiberstufen ausgestaltet sind, so dass hier nicht näher darauf eingegangen werden soll.

Der als Gate G ausgebildete Steuereingang des Power-MOSFETs 18 wird durch eine Steuerschaltung 24, die beispielsweise als ein Micro-Prozessor, ein ASIC oder dergleichen realisiert sein kann, mittels eines pulsweitenmodulierten Signals (PWM) über eine Stromvorsteuerung 25 und einen Steuerausgang 26 angesteuert, wobei ein High-Pegel des PWM-Signals zu einem Einschalten und ein Low-Pegel zu einem Ausschalten des Power-MOSFETs 18 führt. Infolge des PWM-Signals fließt ein Steuerstrom I_{S} als Gatestrom I_{G} vom Steuerausgang 26 in das Gate G des Power-MOSFET 18. Gleichzeitig fällt über dem Übergang zwischen Gate G und Source S des Power-MOSFETs 18 eine Spannung U_{GS} ab.

Die Steuerschaltung 24 ist über Kontakte 28 und 30 mit einem Versorgungspotential V₊ bzw. einem Bezugspotential V. einer Batterie 32 verbunden. Diese Kontakte sind als Anschlüsse 34 bzw. 36 an die Treiberstufe 22 und die Last 12 durchgeschleift, so dass der Power-MOSFET 18 die mit dem Versorgungspotential V₊ verbundene Last 12 im Einschaltfall mit dem Bezugspotential V- verbindet (Low-Side-Schalter). Daraufhin fällt über der Last 12 eine Spannung U_{L} und über dem Übergang zwischen Drain D und Source S des Power-MOSFETs 18 eine Spannung U_{DS} ab, während durch die Reihenschaltung ein Laststrom I_{L} fließt, der im stationären Sättigungszustand einem durch den Power-MOSFET 18 fließenden Drainstrom I_{D} entspricht und den Arbeitspunkt des Power-MOSFET 18 definiert. Der Laststrom I_{L} = I_{D} mit dem höchsten Sättigungswert und der sich daraus ableitende maximale Arbeitspunkt des Power-MOSFET 18 ist abhängig von der jeweiligen Applikation, d.h. zum Beispiel von der maximalen Belastbarkeit der Last 12 und/oder des Power-MOSFET 18. Im Ausschaltfall, d.h. bei Low-Pegel des PWM-Signals, sperrt der Power-MOSFET 18, so dass der in der Last 12 verbliebene Strom durch eine Freilaufdiode 38 über eine Drossel 40 und einen Kondensator 42 abfließen kann. Statt eines Low-Side-Schalters kann selbstverständlich auch ein High-Side-Schalter zum Einsatz kommen, der die Last 12 dann statt mit dem Bezugspotential V- mit dem Versorgungspotential V₊ verbinden würde. Auch die Kombination von High- und Low-Side-Schaltern, wie bei H- und B-Schaltungen üblich, ist ohne Einschränkung der Erfindung möglich.

Das Schalten der Last 12 mittels des Power-MOSFET 18 hat zur Folge, dass zum Einen Schaltverluste im Power-MOSFET 18 und zum Anderen elektromagnetische Störemissionen in einem vorgeschalteten Versorgungsnetz, beispielsweise dem Bordnetz eines nicht gezeigten Kraftfahrzeugs, entstehen. Hierbei gilt es einerseits, die maximal zulässige Verlustleistung im Power-MOSFET 18 nicht zu übersteigen, und andererseits, die geforderten Grenzwerte für die elektromagnetische Verträglichkeit (EMV) nicht zu überschreiten, wobei ein sehr schnelles Schalten mittels PWM eher zu Lasten der EMV und ein langsameres Schalten eher zu Lasten der Verlustleistung geht.

Aus der DE 100 61 563 B4 ist hierzu eine relativ aufwändige, zweiteilige Strom- und Spannungsregelung in Verbindung mit einer Korrekturschaltung zur Linearisierung der nichtlinearen Übertragungscharakteristik eines Leistungshalbleiters bekannt, die gegenüber konventionellen Verfahren eine Reduzierung der elektromagnetischen Störemission bei gleichzeitig verminderter Verlustleistung bewirkt. Das hier vorgeschlagene, erfindungsgemäße Verfahren bietet den Vorteil eines deutlich verminderten Aufwands und damit reduzierter Kosten und Platzerfordernisse bei nahezu ähnlicher Leistungsfähigkeit.

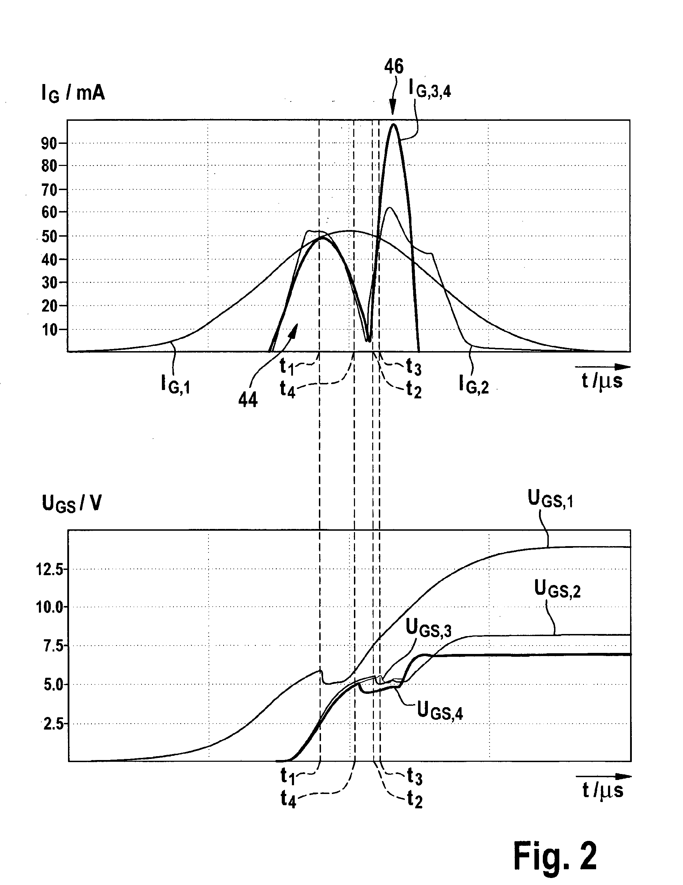

In den Figuren 2 bis 4 sind jeweils vier verschiedene Signalverläufe unterschiedlicher Steuer- und Regelverfahren gegenübergestellt, auf die im Folgenden ausführlicher eingegangen werden soll.

Figur 2 zeigt im oberen Teil den zeitlichen Verlauf des Steuerstroms I_{S} bzw. des Gatestroms I_{G} und im unteren Teil den zeitlichen Verlauf der Gate-Source-Spannung U_{GS} beim Einschalten des Power-MOSFET 18. Die zeitliche Ausdehnung der Abszisse entspricht 4 µs, wobei dies jedoch nicht einschränkend zu sehen ist, da auch deutlich abweichende Schaltzeiten in Abhängigkeit vom verwendeten Leistungshalbleiter 16 möglich sind. Darüber hinaus sei darauf hingewiesen, dass die zu erkennenden Schaltimpulse und Verläufe zum Teil gegeneinander zeitlich verschoben sind, um eine bessere Darstellung zu gewährleisten. Eine Synchronisierung der einzelnen Verfahren erfolgte nicht.

Mit I_{G,1} ist der Steuerstrom bzw. Gatestrom eines konventionellen Steuerverfahrens nach dem Stand der Technik bezeichnet. I_{G,2} symbolisiert den möglichen Verlauf des Gatestroms gemäß einer Simulation, die auf dem Regelverfahren nach der DE 100 61 563 B4 basiert, während I_{G,3,4} die Gateströme des erfindungsgemäßen Verfahrens mit Stromvorsteuerung 25 für einen Arbeitspunkt des Power-MOSFET 18 bei 26 Ampere bzw. 10 Ampere charakterisieren, die im vorliegenden Beispiel identisch sind. Die Nummerierungen 1 bis 4 für die einzelnen Verfahren werden gleichermaßen für sämtliche Signalverläufe der Figuren 2 bis 4 verwendet. Entsprechend zeigt der untere Teil von Figur 2 die Spannungsverläufe der Gate-Source-Spannungen U_{GS,1} nach dem konventionellen Steuerverfahren, U_{GS,2} nach der Simulation gemäß dem in der DE 100 61 563 B4 offenbarten Regelverfahren und U_{GS,3} bzw. U_{GS,4} nach dem erfindungsgemäßen Verfahren mit der Stromvorsteuerung 25.

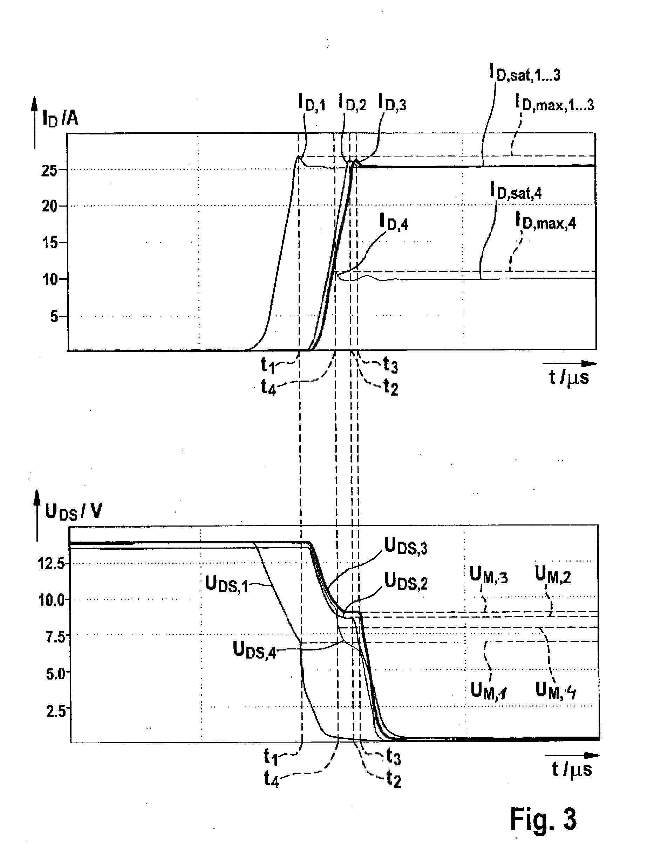

In Figur 3 sind im oberen Teil der Laststrom I_{L} bzw. der Drainstrom I_{D} und im unteren Teil die über dem Power-MOSFET 18 abfallende Drain-Source-Spannung U_{DS} für den Einschaltfall dargestellt. Die zeitliche Ausdehnung der Abszisse entspricht derjenigen von Figur 2. Wiederum sind die Verläufe für das konventionelle Steuerverfahren mit 1, für das gemäß der DE 100 61 563 B4 simulierte Regelverfahren mit 2 und für das erfindungsgemäße Verfahren mit Stromvorsteuerung 25 mit 3 (für einen Arbeitspunkt von I_{L} = 26 A) bzw. 4 (für einen Arbeitspunkt von I_{L} = 10 A) gekennzeichnet.

Nach dem Einschalten des Power-MOSFET 18 gemäß dem konventionellen Steuerverfahren steigen sowohl der Gatestrom I_{G,1} als auch die Gate-Source-Spannung U_{GS} in Figur 2 an. Dies führt mit einer zeitlichen Verzögerung von ca. 1,5 µs zum Durchschalten des Power-MOSFET 18, so dass im oberen Teil von Figur 3 ein starker Anstieg des Drainstrom I_{D,1} bis zu einem Maximalwert I_{D,max,1} zum Zeitpunkt t₁ zu verzeichnen ist. Aufgrund der Rückwirkung der Last 12 über die Gate-Drain-Kapazität des Power-MOSFET 18 erreicht die Drain-Source-Spannung U_{DS,1} im untern Teil von Figur 3 ein Spannungsplateau, das auch als Miller-Plateau U_{M,1} bezeichnet wird. Anschließend schaltet der Power-MOSFET 18 voll durch, so dass U_{DS,1} auf die Durchlassspannung des entsprechenden PN-Übergangs von ca. 0,7 V abfällt. Der Drainstrom I_{D,1} fällt unmittelbar nach seinem Maximalwert I_{D,max,1} auf seinen stationären Sättigungswert I_{D,sat,1} ab, der den Arbeitspunkt des Power-MOSFET (in diesem Fall bei 26 A) definiert. Aus Figur 2 ist weiterhin ersichtlich, dass zum Zeitpunkt t₁ die Gate-Source-Spannung U_{GS} um einen kleinen Betrag einbricht, um dann auf ein stationäres Sättigungsniveau anzusteigen.

Vergleicht man die Kurven des konventionellen Steuerverfahrens (Index 1) mit denen des Regelverfahrens nach der DE 100 61 563 B4 (Index 2), so wird deutlich, dass der zeitliche Verlauf des Last- bzw. Drainstroms I_{D} = I_{L} beim Einschalten des Power-MOSFET 18 bis auf eine zeitliche Verzögerung nahezu identisch ist. Von entscheidendem Unterschied ist jedoch der zeitliche Verlauf des Steuer- bzw. Gatestroms I_{G,2} in Figur 2, der sich aufgrund einer Stromregelung bis zum Erreichen des Maximalstroms I_{D,max,2} (Figur 3) und einer anschließenden Spannungsregelung in zwei Hauptkomponenten unterteilt, die jeweils einen kontrollierten Stromanstieg und -abfall aufweisen. Es sei angemerkt, dass der Verlauf des Steuerstroms I_{G,2} auf einer Simulation basiert, die dem in der DE 100 61 563 B4 beschriebenen Verfahren zugrunde liegt. Zu erkennen ist weiterhin an den Spannungsverläufen der Figuren 2 und 3, dass die Drain-Source-Spannung U_{DS} bis zum Erreichen des Maximalwertes I_{D,max,2} des Drainstroms I_{D,2} zum Zeitpunkt t₂ auf ihr Miller-Plateau U_{M,2} abgefallen ist, um danach sehr schnell auf ihren Endwert nahe Null zu sinken. Entsprechend steigt die Gate-Source-Spannung U_{GS,2} bis zum Zeitpunkt t₂ an, um nach einem kurzem Abfall sehr schnell auf ihren Sättigungswert anzusteigen. Dieses Verhalten ist typisch für einen MOSFET oder IGBT aufgrund der Eingangskapazität und daher unabhängig von den verwendeten Steuer- bzw. Regelverfahren zu beobachten, so dass nachfolgend nicht mehr darauf eingegangen werden soll.

Vergleicht man nun die Störemmissionen E₁ und E₂ der beiden Verfahren gemäß dem Stand der Technik miteinander, so wird deutlich, dass die Simulation des in der DE 100 61 563 B4 offenbarten Regelverfahrens zu deutlich geringeren Werten in einem Frequenzbereich von ca. 25 bis 125 MHz führt, wobei sich die Verlustleistung (nicht dargestellt) nahezu auf gleichem Niveau hält.

Mit den Indizes 3 und 4 sind die zeitlichen Verläufe der Ströme und Spannungen in den Figuren 2 und 3 für das erfindungsgemäße Verfahren unter Verwendung einer Stromvorsteuerung 25 bei einem Arbeitspunkt von 26 A (Index 3) und 10 A (Index 4) gekennzeichnet. Figur 2 zeigt, dass sich die Steuerströme I_{G,3} und I_{G,4} nicht voneiander unterscheiden. In beiden Fällen sind sie im Wesentlichen in mindestens zwei Halbwellen 44 und 46 aufgeteilt, wobei die erste Halbwelle 44 eine in etwa halb so hohe Amplitude und eine in etwa doppelt so lange Dauer aufweist wie die zweite Halbwelle 46. Der Verlauf der beiden Halbwellen 44, 46 entspricht jeweils in etwa einer positiven Sinushalbwelle.

Betrachtet man zunächst den Arbeitspunkt von I_{D,sat,3} = 26 A, so wird aus Figur 3 deutlich, dass sowohl der Drain- bzw. Laststrom I_{D,3} als auch die über dem Power-MOSFET 18 abfallende Drain-Source-Spannung U_{DS,3} eine sehr starke Übereinstimmung mit dem Drainstrom I_{D,2} und der Drain-Source-Spannung U_{DS,2} nach dem Regelverfahren der DE 100 61 563 B4 aufweisen, wobei der Maximalwert I_{D,max,3} und das Miller-Plateau U_{M,3} zum Zeitpunkt t₃ erreicht werden.

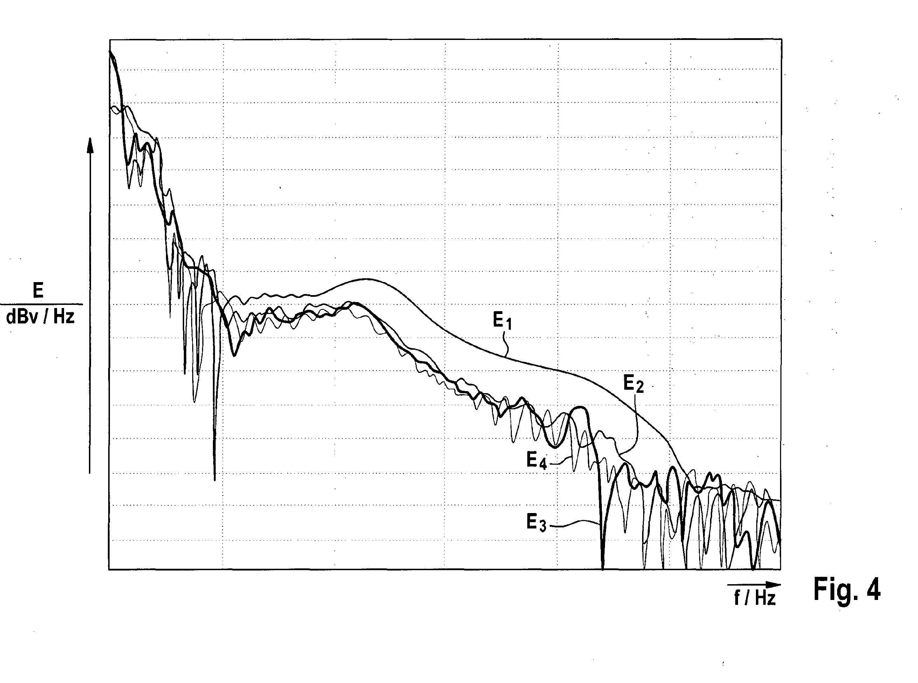

Im Unterschied zur Simulation des Regelverfahren gemäß der DE 100 61 563 B4 erfolgt das Einschalten des Power-MOSFET 18 nun jedoch über eine sehr einfache Stromvorsteuerung 25 derart, dass das Gate G des Power-MOSFETs 18 gemäß Figur 2 bis in etwa zum Zeitpunkt t₃ des Maximalwerts I_{D,max,3} des in Figur 3 dargestellten Last- bzw. Drainstroms I_{D,3} mit der ersten Halbwelle 44 und ab dem Zeitpunkt t₃ mit der zweiten Halbwelle 46 beaufschlagt wird. Aus Figur 4 ist zu erkennen, dass die Störemission E₃ nahezu dasselbe Niveau erreicht, wie die Störemission E₂ des Regelverfahrens gemäß der DE 100 61 563 B4.

Für einen Arbeitspunkt von I_{D,sat,4} = 10 A kann den Figuren 3 und 4 entnommen werden, dass sich bei identischer Stromvorsteuerung 25 (vgl. Figur 2), d.h. I_{G,4} ≡ I_{G,3}, zwar ein leicht verändertes Miller-Plateau U_{M,4} zum Zeitpunkt t₄ des Maximalwertes I_{D,max,4} des Laststroms I_{D,4} ergibt, die Störemission E₄ jedoch weiterhin auf dem sehr geringen Niveau der Störemission E₃ bei reduzierter Verlustleistung verbleibt. Somit wird deutlich, dass das erfindungsgemäße Verfahren sehr robust ist gegenüber einer Veränderung des Arbeitspunktes des Power-MOSFET 18, wenn die Stromvorsteuerung 25 so eingestellt wird, dass für den Arbeitspunkt des Power-MOSFET 18, der dem höchsten Sättigungswert des Laststroms I_{D} entspricht - in diesem Fall also der Sättigungswert I_{D,sat,3} = 26 A-nach der ersten Halbewelle 44 dann die zweite Halbwelle 46 folgt, wenn der Laststrom I_{D} in etwa seinen Maximalwert, also I_{D.max,3} ≈ 27 A, erreicht hat.

Die Stromvorsteuerung 25 kann durch eine einfache Regelung 48 (in Figur 1 gestrichelt dargestellt) unterlagert werden, um die Temperaturstabilität der Treiberstufe und die Präzision des Einschaltvorgangs weiter zu erhöhen sowie etwaige Schaltstreuungen zu reduzieren. Dabei kann ein nicht gezeigter PI-Regler oder dergleichen zum Einsatz kommen. Als Regelgröße können in diesem Fall zum Beispiel die Drain-Source-Spannung U_{DS} oder der Drain- oder Laststrom I_{D} bzw. I_{L} dienen. Da dem Fachmann eine unterlagerte Regelung vom Prinzip her bekannt ist, soll hierauf nicht näher eingegangen werden.

Es sei abschließend noch darauf hingewiesen, dass das gezeigte Ausführungsbeispiel weder auf die Figuren 1 bis 4 noch auf die in den Diagrammen aufgezeigten Werte beschränkt ist. So können sich in Abhängigkeit von der Applikation und dem verwendeten Leistungshalbleiter 16 auch abweichende Strom- und Spannungwerte ergeben. Darüber hinaus ist das dargestellte Verhältnis der beiden Halbwellen 44 und 46 zueinander nicht einschränkend zu betrachten. So kann die zweite Halbwelle 46 auch durchaus eine höhere oder geringere Amplitude und/oder Dauer im Verhältnis zur ersten Halbwelle 44 aufweisen, als dargestellt.

## Patentansprüche

1. Verfahren zur Reduzierung elektromagnetischer Emissionen beim Einschaltvorgang eines Leistungshalbleiters (16) mittels einer Stromvorsteuerung (25), wobei der Leistungshalbleiter (16) eine Last (12) derart ansteuert, dass nach dem Einschalten ein Laststrom (I_{L}, I_{D,3}, I_{D,4}) durch die Last (12) und den Leistungshalbleiter (16) fließt, dessen Sättigungswert (I_{D,sat,3}, I_{D,sat,4}) einen Arbeitspunkt des Leistungshalbleiters (16) definiert, und wobei sich für unterschiedliche Sättigungswerte (I_{D,sat,3}, I_{D,sat,4}) des Laststroms (I_{L}, I_{D,3}, I_{D,4}) unterschiedliche Arbeitspunkte des Leistungshalbleiters (16) ergeben, wobei ein durch die Stromvorsteuerung (25) vorgegebener Steuerstrom (I_{S}, I_{G,3}, I_{G,4}) im Wesentlichen in mindestens zwei aufeinanderfolgende Halbwellen (44, 46) aufgeteilt wird, wobei für den Arbeitspunkt des Leistungshalbleiters (16), der dem höchstem Sättigungswert (I_{D,sat,3}) des Laststroms (I_{D,3}) entspricht, nach einer ersten Halbwelle (44) dann eine weitere Halbwelle (46) folgt, wenn der Laststrom (I_{L}, I_{D,3}) in etwa seinen Maximalwert (I_{D,max,3}) erreicht hat, **dadurch gekennzeichnet, dass** die Dauer der zweiten Halbwelle (46) des Steuerstroms (I_{S}, I_{G,3}, I_{G,4}) kürzer ist als die der ersten Halbwelle (44).

2. Verfahren nach Anspruch 1, **dadurch gekennzeichnet, dass** die zeitliche Aufteilung der Halbwellen (44, 46) des Steuerstroms (I_{S}, I_{G,3}, I_{G,4}) bei Arbeitspunkten des Leistungshalbleiters (16), die geringeren Sättigungswerten (I_{D,sat,4}) als dem höchsten Sättigungswert (I_{D,sat,3}) entsprechen, unverändert bleibt.

3. Verfahren nach einem der vorhergehenden Ansprüche, **dadurch gekennzeichnet, dass** die Halbwellen (44, 46) des Steuerstroms (I_{S}, I_{G,3}, I_{G,4}) jeweils nahezu einer positiven Sinushalbwelle entsprechen.

4. Verfahren nach einem der vorhergehenden Ansprüche, **dadurch gekennzeichnet, dass** die Amplitude der zweiten Halbwelle (46) des Steuerstroms (I_{S}, I_{G,3}, I_{G,4}) höher ist als die der ersten Halbwelle (44).

5. Verfahren nach einem der vorhergehenden Ansprüche, **gekennzeichnet durch** eine unterlagerte Regelung (48), insbesondere eine unterlagerte P0I-Regelung, deren Regelgröße die Drain-Source-Spannung (U_{DS}) oder der Drainstrom (I_{D,3}, I_{D,4}) bzw. der Laststrom (I_{L}) ist.

6. Vorrichtung (10) mit wenigstens einem Leistungshalbleiter (16) und einer Stromvorsteuerung (25) zur Durchführung des Verfahrens nach einem der Ansprüche 1 bis 5.

7. Vorrichtung (10) nach Anspruch 6, **dadurch gekennzeichnet, dass** der Leistungshalbleiter (16) ein MOSFET (18) oder ein IGBT (20) ist.

8. Vorrichtung (10) nach Anspruch 7, **dadurch gekennzeichnet, dass** der Steuerstrom (I_{S}) der Gatestrom (I_{G,3}, I_{G,4}) des MOSFETs (18) oder des IGBTs (20) ist.

9. Vorrichtung (10) nach einem der vorhergehenden Ansprüche 7 oder 8, **dadurch gekennzeichnet, dass** der Laststrom (I_{L}) dem Drainstrom (I_{D,3}, I_{D,4}) des MOSFETs (18) oder dem Kollektorstrom des IGBTs (20) entspricht.

## Claims

1. Method for reducing electromagnetic emissions during the switch-on operation of a power semiconductor (16) by means of current pre-control (25), the power semiconductor (16) controlling a load (12) in such a manner that, after switch-on, a load current (I_{L}, I_{D,3}, I_{D,4}) flows through the load (12) and the power semiconductor (16), the saturation value (I_{D,sat,3}, I_{D,sat,4}) of which defines an operating point of the power semiconductor (16), and different operating points of the power semiconductor (16) resulting for different saturation values (I_{D,sat,3}, I_{D,sat,4}) of the load current (I_{L}, I_{D,3}, I_{D,4}), a control current (I_{S}, I_{G,3}, I_{G,4}) predefined by the current pre-control (25) being divided substantially into at least two successive half-waves (44, 46), in which case, for the operating point of the power semiconductor (16) corresponding to the highest saturation value (I_{D,sat,3}) of the load current (I_{D,3}), a further half-wave (46) follows a first half-wave (44) when the load current (I_{L}, I_{D,3}) has reached approximately its maximum value (I_{D,max,3}), **characterized in that** the duration of the second half-wave (46) of the control current (I_{S}, I_{G,3}, I_{G,4}) is shorter than that of the first half-wave (44).

2. Method according to Claim 1, **characterized in that** the temporal division of the half-waves (44, 46) of the control current (I_{S}, I_{G,3}, I_{G,4}) remains unchanged at operating points of the power semiconductor (16) which correspond to saturation values (I_{D,sat,4}) lower than the highest saturation value (I_{D,sat,3}).

3. Method according to one of the preceding claims, **characterized in that** the half-waves (44, 46) of the control current (I_{S}, I_{G,3}, I_{G,4}) each virtually correspond to a positive sine half-wave.

4. Method according to one of the preceding claims, **characterized in that** the amplitude of the second half-wave (46) of the control current (I_{S}, I_{G,3}, I_{G,4}) is higher than that of the first half-wave (44).

5. Method according to one of the preceding claims, **characterized by** subordinate control (48), in particular subordinate PI control, the controlled variable of which is the drain-source voltage (U_{DS}) or the drain current (I_{D,3}, I_{D,4}) or the load current (I_{L}).

6. Apparatus (10) having at least one power semiconductor (16) and current pre-control (25) for carrying out the method according to one of Claims 1 to 5.

7. Apparatus (10) according to Claim 6, **characterized in that** the power semiconductor (16) is a MOSFET (18) or an IGBT (20).

8. Apparatus (10) according to Claim 7, **characterized in that** the control current (Is) is the gate current (I_{G,3}, I_{G,4}) of the MOSFET (18) or of the IGBT (20).

9. Apparatus (10) according to either of the preceding Claims 7 and 8, **characterized in that** the load current (I_{L}) corresponds to the drain current (I_{D,3}, I_{D,4}) of the MOSFET (18) or to the collector current of the IGBT (20).

## Revendications

1. Procédé pour réduire au moyen d'une pré-commande de courant (25) les émissions électromagnétiques lors d'une opération de branchement d'un semi-conducteur de puissance (16),
le semi-conducteur de puissance (16) commandant une charge (12) de telle sorte qu'après le branchement, un courant de charge (I_{L}, I_{D,3}, I_{D,4}) dont la valeur de saturation (I_{D,sat,3}, I_{D,sat,4}) définit un point de travail du semi-conducteur de puissance (16) traverse la charge (12) et le semi-conducteur de puissance (16),
différents points de travail du semi-conducteur de puissance (16) s'établissant pour différentes valeurs de saturation (I_{D,sat,3}, I_{D,sat,4}) du courant de charge (I_{L}, I_{D,3}, I_{D,4}),
un courant de commande (I_{S}, I_{G,3}, I_{G,4}) prédéterminé par la pré-commande de courant (25) étant divisé essentiellement en au moins deux demi-ondes successives (44, 46),
une deuxième demi-onde (46) suivant une première demi-onde (44) pour le point de travail du semi-conducteur de puissance (16) qui correspond à la valeur de saturation (I_{D,sat,3}) la plus élevée du courant de charge (I_{D,3}) lorsque le courant de charge (I_{L}, I_{D,3}) a atteint sensiblement sa valeur maximale (I_{D,max,3}), **caractérisé en ce que**
la durée de la deuxième demi-onde (46) du courant de commande (I_{S}, I_{G,3}, I_{G,4}) est plus courte que celle de la première demi-onde (44).

2. Procédé selon la revendication 1, **caractérisé en ce que** la division dans le temps des demi-ondes (44, 46) du courant de commande (I_{S}, I_{G,3}, I_{G,4}) reste inchangée aux points de travail du semi-conducteur de puissance (16) qui correspondent à des valeurs de saturation (I_{D,sat,4}) plus basses que la valeur de saturation (I_{D,sat,3}) la plus élevée.

3. Procédé selon l'une des revendications précédentes, **caractérisé en ce que** les demi-ondes (44, 46) du courant de commande (I_{S}, I_{G,3}, I_{G,4}) correspondent chacune sensiblement à une demi-onde sinusoïdale positive.

4. Procédé selon l'une des revendications précédentes, **caractérisé en ce que** l'amplitude de la deuxième demi-onde (46) du courant de commande (I_{S}, I_{G,3}, I_{G,4}) est plus élevée que celle de la première demi-onde (44).

5. Procédé selon l'une des revendications précédentes, **caractérisé par** une régulation sous-jacente (48), en particulier une régulation PI sous-jacente dont la grandeur de réglage est la tension drain-source (U_{DS}), le courant de drain (I_{D,3}, I_{D,4}) ou le courant de charge (I_{L}).

6. Dispositif (10) présentant au moins un semi-conducteur de puissance (16) et une pré-commande de courant (25) en vue de la mise en oeuvre du procédé selon l'une des revendications 1 à 5.

7. Dispositif (10) selon la revendication 6, **caractérisé en ce que** le semi-conducteur de puissance (16) est un MOSFET (18) ou un IGBT (20).

8. Dispositif (10) selon la revendication 7, **caractérisé en ce que** le courant de commande (I_{S}) est le courant de grille (I_{G,3}, I_{G,4}) du MOSFET (18) ou de l'IGBT (20).

9. Dispositif (10) selon l'une des revendications 7 ou 8 qui précèdent, **caractérisé en ce que** le courant de charge (I_{L}) correspond au courant de drain (I_{D,3}, I_{D,4}) du MOSFET (18) ou au courant de collecteur de l'IGBT (20).
